# EUROPÄISCHE PATENTSCHRIFT

(11) **EP 1 499 168 B1**
(45) Veröffentlichungstag und Bekanntmachung des Hinweises auf die Patenterteilung: **20.06.2012**
(21) Anmeldenummer: 04011435.7
(22) Anmeldetag: 13.05.2004
(51) Int. Cl.: H05K 3/30, H01L 25/00

(54) **Verfahren und Vorrichtung zum Herstellen eines Systems mit einer an einer vorbestimmten Stelle einer Oberfläche eines Substrats aufgebrachten Komponente**
Method and apparatus for manufacturing a system comprising a component placed at a predetermined place on the surface of a substrate
Procédé et dispositif pour la réalisation d'un système comprenant un composant disposé à une position predeterminée à la surface d'un substrat

(30) Priorität: 05.06.2003 DE 10325559
(43) Veröffentlichungstag der Anmeldung: 19.01.2005
(73) Patentinhaber: Fraunhofer-Gesellschaft zur Förderung der angewandten Forschung e.V., 80686 München (DE)
(72) Erfinder: Bock, Karlheinz, 82110 Germering (DE)
(74) Vertreter: Schoppe, Fritz

(56) Entgegenhaltungen:
- WO-A-03/022581
- US-B1- 6 527 964
- XIAORONG XIONG, YAEL HANEIN, JIANDONG FANG, YANBING WNG, WEIHUA WANG, DANIEL T. SCHWARTZ, KARL BÖHRINGER: "Controlled Multibatch Self-Assembly of Microdevices" JOURNAL OF MICROELECTROMECHANICAL SYSTEMS, Bd. 12, Nr. 2, April 2003 (2003-04), Seiten 117-127, XP002448614
- XIAORONG XIONG, YAEL HANEIN, WEIHUA WANG, DANIEL T. SCHWARTZ, KARL F. BÖHRINGER: "Multi-Batch Micro-Selfassembly via Controlled Capillary Forces" PROCEEDINGS OF THE 2001 IEEE/RSJ INTERNATIONAL CONFERENCE ON INTELLIGENT ROBOTS AND SYSTEMS, 29. Oktober 2001 (2001-10-29), - 3. November 2001 (2001-11-03) Seiten 1335-1342, XP002448615 Maui, Hawaii, USA

## Beschreibung

Die vorliegende Erfindung bezieht sich auf ein Verfahren und eine Vorrichtung zum Herstellen eines Systems mit einem Substrat mit einer Oberfläche und einer an einer vorbestimmten Stelle der Oberfläche des Substrats aufgebrachten Komponente, insbesondere einer mikroelektronischen oder mikromechanischen Komponente.

Herkömmlich werden elektronische, mikroelektronische oder mikromechanische Komponenten bzw. Bauelemente im sogenannten Pick-And-Place-Verfahren auf Platinen, Halbleiter- und andere Substrate oder ein Package bzw. eine Montageeinheit aufgebracht. Dabei werden die Komponenten auf verschiedenen Trägersystemen, beispielsweise Bändern, bereitgestellt. Ein Greifer erfaßt bzw. greift jede einzelne Komponente, bewegt sie von dem Trägersystem zu dem Substrat, justiert siebeispielsweise aufgrund optisch erfaßter Informationen zur relativen räumlichen Anordnung von Substrat und Komponente - und bringt sie in das Substrat ein bzw. an dem Substrat an. Gleichzeitig erfolgt im Fall elektronischer oder mikroelektronischer Komponenten eine Kontaktierung bzw. eine Herstellung von einem oder mehreren elektrischen Kontakten zwischen dem Substrat und der Komponente mittels eines geeigneten Kontaktierungsprozesses bzw. -mechanismus, wie z. B. des Flip-Chip-Verfahrens.

Je kleiner die Komponente ist, desto genauer muß sie in der Regel ausgerichtet werden und desto mehr Aufwand muß für ihre genaue Justage betrieben werden. Die beschriebenen Prozesse bzw. Verfahrensschritte und damit das Bestücken eines Substrats mit Komponenten mittels eines Pick-And-Place-Verfahrens ist deshalb in der Regel sehr zeitintensiv. Deshalb ist in der Produktion nur ein begrenzter Durchsatz erreichbar. Beispielsweise bearbeiten die schnellsten Pick-And-Place-Die-Bond-Maschinen nur etwa 12.000 Einheiten bzw. Komponenten pro Stunde. Insbesondere für hochvolumige Produktkategorien bzw. Produktkategorien mit großen Produktionsvolumina stellt die herkömmliche Bestückung bzw. Assemblierung deshalb ein unüberwindliches Hindernis für eine Steigerung des Produktionsvolumens dar. Dies wird als Assembly-Krise bezeichnet.

Das US-Patent Nr. 6,527,964 offenbart ein Verfahren und eine Vorrichtung für einen verbesserten Fluss beim Durchführen eines fluidischen Selbstausrichtungsverfahrens. Die Oberflächen der Elemente und/oder des Substrats werden behandelt, und die Elemente werden über das Substrat in einem Schlamm aufgebracht. Das Substrat wird mit einem Oberflächenbehandlungs-Fluid behandelt, um eine Oberfläche auf dem Substrat zu bilden, die eine hydrophile oder hydrophobe Charakteristik hat. Dann wird ein Schlamm über dem Substrat aufgebracht, wobei der Schlamm ein Fluid und eine Mehrzahl von Elementen umfasst, von denen jedes eine Funktionskomponente aufweist. Die aufzubringenden Blöcke können in einer geneigten Röhre mit dem Fluid fließen, wobei der Fluid-Fluss auch laminar oder turbulent sein kann, um ein Sprühen des Block-Schlamms über das Substrat zu erreichen, um einen ausgewähften Abschnitt oder das gesamte Substrat zu bedecken.

Der vorliegenden Erfindung liegt die Aufgabe zugrunde, ein Verfahren und eine Vorrichtung zum Herstellen eines Systems mit einem Substrat und einer an einer vorbestimmten Stelle einer Oberfläche des Substrats aufgebrachten Komponente zu schaffen, die von einer Geschwindigkeit eines Greifers unabhängig ist.

Diese Aufgabe wird durch ein Verfahren gemäß Patentanspruch oder 19. eine Vorrichtung gemäß Patentanspruch 18 oder 20 gelöst.

Der vorliegenden Erfindung liegt die Erkenntnis zugrunde, daß elektronische, mikroelektronische und mikromechanische Komponenten, beispielsweise integrierte Schaltungen im Zuge der rasch fortschreitenden allgemeinen Miniaturisierung immer kleiner werden.

Die vorliegende Erfindung beruht auf der Idee, Mikrochips und andere miniaturisierte Komponenten in einem Tropfen eines flüssigen Mediums beinhaltet durch ein Tintenstrahldruckverfahren oder auch durch andere Drucktechniken auf ein Substrat aufzubringen. Allgemeiner formuliert besteht die Idee der vorliegenden Erfindung darin, Komponenten in ein flüssiges Medium einzubringen und Tropfen oder andere kleine Volumina dieses flüssigen Mediums zu erzeugen und auf das Substrat aufzubringen. Das Flüssigkeitsvolumen ist dabei so dimensioniert, daß es nach dem Aufbringen auf das Substrat nur einen Teilbereich von dessen Oberfläche benetzt.

Insbesondere mit einem Tintenstrahldruckverfahren können sehr kleine Tröpfchen des flüssigen Mediums sehr ortgenau und gleichzeitig sehr schnell und sehr kostengünstig auf einem Substrat plaziert werden. Ein wichtiger Vorteil der vorliegenden Erfindung besteht somit darin, daß sie weder auf die Geschwindigkeit eines Greifers noch auf dessen Fähigkeit, eine sehr kleine Komponente zu greifen und auszurichten, angewiesen ist. Die vorliegende Erfindung nutzt vielmehr den verglichen mit einem Greifer extrem hohen Durchsatz, mit dem Flüssigkeitsvolumina, beispielsweise mittels des genannten Tintenstrahldruckens, auf ein Substrat aufbringbar sind. Ferner nutzt die vorliegende Erfindung die dabei gleichzeitig erzielbare hohe Präzision. In diesem Zusammenhang wird auf die Druckgeschwindigkeit sowie die Auflösung hingewiesen, die moderne Tintenstrahldrucker erreichen. Dadurch kann ein Flüssigkeitsvolumen so auf einer Oberfläche eines Substrats plaziert werden, daß der (sehr kleine) benetzte Teilbereich der Oberfläche diejenige vorbestimmte Stelle umfaßt, an der die Komponente auf das Substrat aufgebracht werden soll.

Ferner beruht die vorliegende Erfindung auf der Idee, besondere Oberflächenstrukturen auf der Komponente bzw. dem Mikrochip oder dem Substrat zu verwenden, um, vorzugsweise in Zusammenwirken mit dem flüssigen Medium, eine laterale Selbstjustage und vorzugsweise gleichzeitig eine Ausrichtung der Komponente relativ zu dem Substrat zu bewirken.

Allgemeiner formuliert sind gemäß der vorliegenden Erfindung die Komponente oder die vorbestimmte Stelle der Oberfläche des Substrats, an der die Komponente aufzubringen ist, so ausgebildet, daß nach dem Aufbringen des Flüssigkeitsvolumens eine Kraft auf die Komponente wirkt, die ausreichend ist, um alleine oder beispielsweise zusammen mit einer Brown' schen Bewegung der Komponente dieselbe innerhalb des Flüssigkeitsvolumens zu der vorbestimmten Stelle zu treiben bzw. zu bewegen.

Da gemäß der vorliegenden Erfindung ein vorzugsweise sehr kleines Flüssigkeitsvolumen vorzugsweise sehr genau an dem Ort aufgebracht wird, an dem die Komponente an der Oberfläche des Substrats aufzubringen ist bzw. später ihre Funktion zu erfüllen hat, wird die Komponente sehr schnell und ohne weiteres Zutun von außen die vorbestimmte Stelle erreichen. Anders ausgedrückt wird gemäß der vorliegenden Erfindung im Gegensatz zu einem reinen Self-Assembly-Verfahren, bei dem das gesamte Substrat in eine Flüssigkeit eingetaucht wird, die die Komponente enthält, ein großer Teil des Wahrscheinlichkeitsprozesses der Annäherung der Komponente an die vorbestimmte Stelle vermieden bzw. abgekürzt. Ein solcher Wahrscheinlichkeitsprozeß wäre beispielsweise eine Zufallsbewegung der Komponente, die für ein großes Flüssigkeitsvolumen durch eine Strömung, durch Durchleiten eines Gases oder durch Ultraschall unterstützt werden müßte. Gemäß der vorliegenden Erfindung erfolgt nur noch die Endjustage der Komponente an der vorbestimmten Stelle an der Oberfläche des Substrats innerhalb des Flüssigkeitströpfchens.

Gemäß einem bevorzugten Ausführungsbeispiel der vorliegenden Erfindung umfassen die Oberflächenstrukturen hydrophile und hydrophobe bzw. lipophobe und lipophile Schichten bzw. Abschnitte oder Schichten bzw. Abschnitte mit komplementären Makromolekülpaaren, beispielsweise DANN, wobei die Schichten bzw. Abschnitte in geeigneten graphischen Mustern angeordnet sind.

Gemäß einem weiteren bevorzugten Ausführungsbeispiel der vorliegenden Erfindung umfaßt das Flüssigkeitsvolumen eine schnell bzw. sehr schnell flüchtige Flüssigkeit bzw. ein ebensolches Medium. Dies ist insbesondere der Fall, wenn Ausrichtung und Anlagerung der Komponente an der vorbestimmten Stelle an der Oberfläche des Substrats nicht durch die Flüssigkeitskräfte, sondern beispielsweise durch mechanische, elektrostatische oder andere Effekte erfolgen sollen. Vorzugsweise entstehen beim Abtrocknen der Flüssigkeit elektrische Kontakte oder weiterverarbeitbare Vorstufen von Kontakten. Ferner wird die Komponente beim Abtrocknen der Flüssigkeit vorzugsweise auf dem Substrat fixiert.

Die vorliegende Erfindung schafft somit ein Verfahren, bei dem Komponenten nach dem Vereinzeln nicht mehr einzeln durch ein Pick-And-Place-Verfahren auf ein Substrat bzw. in eine Schaltung eingebracht werden müssen, sondern, beispielsweise mittels eines Tintenstrahldruckverfahrens oder eines anderen Druckverfahrens, sehr schnell und sehr präzise aufgebracht werden.

Nachfolgend werden bevorzugte Ausführungsbeispiele der vorliegenden Erfindung anhand der beiliegenden Figuren näher erläutert. Es zeigen:
- Fig. 1 bis 4: schematische Darstellungen eines Substrats mit einer Komponente während eines Verfah- rens gemäß bevorzugten Ausführungsbeispielen der vorliegenden Erfindung;
- Fig. 5 bis 7: schematische Darstellungen eines Substrats mit einer Komponente in verschiedenen Stadi- en eines Verfahrens gemäß einem bevorzugten Ausführungsbeispiel der vorliegenden Erfin- dung; und
- Fig. 8A und 8B: schematische Darstellungen einer Vorrichtung für die Durchführung eines alternativen Ver- fahrens gemäß der vorliegenden Erfindung.

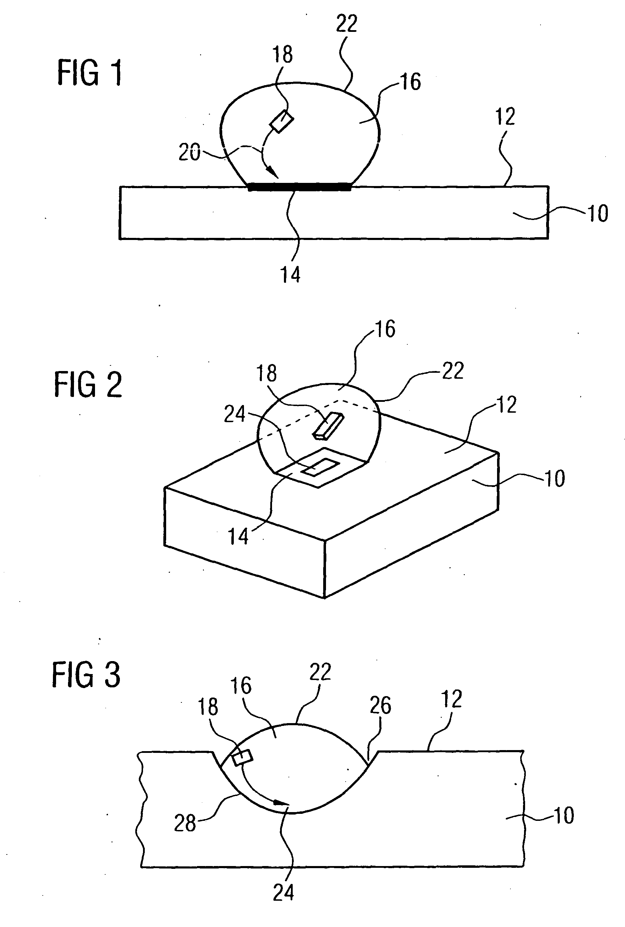

Fig. 1 ist eine schematische Darstellung eines Substrats 10 mit einer Oberfläche 12 gemäß einem ersten Ausführungsbeispiel der vorliegenden Erfindung. Ein Teilbereich 14 der Oberfläche 12 wird von einem Flüssigkeitsvolumen 16 benetzt, das eine Komponente 18 enthält. Das Substrat 10 ist beispielsweise eine Leiterplatte, ein Keramiksubstrat, Papier oder Folie, ein Halbleitersubstrat oder ein anderes Substrat, auf das bzw. auf dessen Oberfläche 12 die Komponente 18 aufgebracht werden soll. Die Komponente 18 ist beispielsweise ein elektronisches, mikroelektronisches oder mikromechanisches Bauelement, das seinerseits beispielsweise aus einem Halbleitermaterial oder aus Kunststoff besteht. Die Komponente 18 wurde beispielsweise mit vielen anderen gleichartigen Komponenten gemeinsam in einem Bauelementsubstrat gebildet und dann vereinzelt. Die Komponente 18 weist vorzugsweise Abmessungen im Bereich von 1 nm bis zu einem oder wenigen mm auf.

Das Flüssigkeitsvolumen 16, das die Komponente enthält, ist hier ein Tropfen, der beispielsweise durch eine Tintenstrahldruckvorrichtung ähnlich einem Druckkopf eines herkömmlichen Tintenstrahldruckers auf die Oberfläche 12 des Substrats 10 aufgebracht wurde. Die laterale Anordnung, die Form und die Größe des Teilbereichs 14 der Oberfläche 12 des Substrats 10, der von dem Flüssigkeitsvolumen 16 benetzt wird, ist vorzugsweise durch den Tintenstrahldruckvorgang bestimmt, d. h. durch den Ort, auf den die Düse des Tintenstrahldruckkopfes gerichtet war, als dieser das Flüssigkeitsvolumen 16 ausstieß, sowie durch die Größe des Flüssigkeitsvolumens 16 und die Geschwindigkeit, mit der es auf die Oberfläche 12 des Substrats 10 auftraf. Alternativ sind die genaue laterale Anordnung, die Form und die Größe des Teilbereichs 14 ferner durch eine vorbestimmte Beschaffenheit der Oberfläche 12 des Substrats 10 bestimmt. Beispielsweise ist der Teilbereich 14 der Oberfläche 12 bereits vor dem Aufbringen des Flüssigkeitsvolumens 16 hydrophil präpariert worden, während angrenzende Bereiche der Oberfläche 12 hydrophob sind und das Flüssigkeitsvolumen 16 eine polare Flüssigkeit umfaßt. Dadurch wird bewirkt, daß das Flüssigkeitsvolumen 16, auch wenn es unmittelbar nach dem Auftreffen auf die Oberfläche 12 des Substrats 10 nur teilweise mit dem Teilbereich 14 überlappt, spontan die in Fig. 1 gezeigte Position und Form einnimmt, bei welcher der gesamte Teilbereich 14, aber nur dieser, benetzt ist.

Alternativ weist das Flüssigkeitsvolumen 16 eine unpolare Flüssigkeit auf und der Teilbereich 14 ist lipophil, wobei ein an den Teilbereich 14 angrenzender Teilbereich der Oberfläche 12 lipophob ist.

Die in dem Flüssigkeitsvolumen 16 enthaltene Komponente 18 befindet sich unmittelbar nach dem Aufbringen des Flüssigkeitsvolumens 16 auf den Teilbereich 14 der Oberfläche 12 an einem beliebigen Ort innerhalb des Flüssigkeitsvolumens 16. Die Komponente 18 ist so ausgebildet, daß nach dem Aufbringen des Flüssigkeitsvolumens 16 eine Kraft auf sie wirkt, die sie zu einer für sie vorbestimmten Stelle treibt.

Ein Beispiel für diese Kraft ist die Schwerkraft. Dabei ist die Komponente 18 so ausgebildet, daß ihr spezifisches Gewicht größer ist als das der Flüssigkeit des Flüssigkeitsvolumens 16. Wenn der gesamte Teilbereich 14 die für die Komponente 18 vorbestimmte Stelle darstellt, wird das Substrat 10 horizontal mit der Oberfläche 12 nach oben, d. h. vom Erdmittelpunkt abgewandt, angeordnet. Die Komponente 18 fällt dann gebremst durch die Viskosität der Flüssigkeit des Flüssigkeitsvolumens 16 auf den Teilbereich 14. Diese Bewegung ist durch den Pfeil 20 angedeutet. Auf die Komponente 18 wirken hydrodynamische Kräfte, welche außer bei einer Kugelform der Komponente 18 von der räumlichen Orientierung der Komponente 18 abhängen. Außerdem wird die Bewegung der Komponente 18 beispielsweise durch die sogenannte Brown'sche Bewegung beeinflußt. Aus beiden Gründen legt die Komponente 18 einen Weg 20 zurück, der nicht notwendig geradlinig verläuft, sondern, wie in Fig. 1 dargestellt, eine oder mehrere diskrete oder aber auch kontinuierliche Richtungsänderungen umfassen kann. Alternativ ist die Komponente 18 so ausgebildet, daß ihr spezifisches Gewicht geringer ist als das der Flüssigkeit des Flüssigkeitsvolumens 16. Die Komponente 18 nähert sich in diesem Fall erst dann dem Teilbereich 14, wenn das Substrat 10 mit dem Flüssigkeitsvolumen 16 so gehalten wird, daß die Oberfläche 12 dem Erdmittelpunkt zugewandt ist.

In beiden Fällen ist die Zeit, die die Komponente 18 benötigt, um auf den Teilbereich 14 aufzutreffen, von ihrem ursprünglichen Ort innerhalb des Flüssigkeitsvolumens 16, von der Größe des Flüssigkeitsvolumens 16, von der Viskosität der Flüssigkeit des Flüssigkeitsvolumens 16, von der Differenz der Dichten der Komponente 18 und der Flüssigkeit des Flüssigkeitsvolumens 16 und von den hydrodynamischen Eigenschaften der Komponente 18, insbesondere ihrer Form und Größe, abhängig.

Die vorbestimmte Stelle, an der die Komponente auf die Oberfläche 12 des Substrats 10 aufgebracht werden soll, kann auch genauer bestimmt sein, als in Fig. 1 dargestellt. Gemäß einem Ausführungsbeispiel weist der Rand des Teilbereiches 14 eine Ecke auf, deren Ort die vorbestimmte Stelle für die Komponente 18 darstellt. Im Falle einer Komponente 18, die schwerer ist als die durch sie verdrängte Flüssigkeit des Flüssigkeitsvolumens 16, wird das Substrat 10 räumlich so ausgerichtet, daß die genannte Ecke den tiefsten Punkt des Flüssigkeitsvolumens 16 darstellt. Die Komponente 18 fällt in diesem Fall automatisch bis zu der ihr vorbestimmten Stelle. Im Falle einer Komponente 18, die leichter als die durch sie verdrängte Flüssigkeit des Flüssigkeitsvolumens 16 ist, wird das Substrat 10 so gehalten, daß die genannte Ecke den höchsten Punkt des Flüssigkeitsvolumens 16 bildet.

Im Fall einer Komponente 18, die bei der ersten Berührung mit dem Teilbereich 14 an diesem haften bleibt, wird das Substrat 10 zunächst so ausgerichtet, daß die Komponente 18 den Teilbereich 14 zunächst noch nicht berühren kann. Im Fall einer Komponente 18, deren Dichte größer als die der Flüssigkeit des Flüssigkeitsvolumens 16 ist, wird dazu das Substrat 10 zunächst so räumlich ausgerichtet, daß die Oberfläche 12 senkrecht steht oder sogar zumindest teilweise dem Erdmittelpunkt zugewandt ist. Das Substrat 10 verbleibt in dieser räumlichen Ausrichtung, bis mit hoher Wahrscheinlichkeit davon ausgegangen werden kann, daß die Komponente 18 auf die Oberfläche 22 des Flüssigkeitsvolumens 16 gefallen ist, wobei die Oberfläche 22 die Grenzfläche zwischen dem Flüssigkeitsvolumen 16 und der umgebenden Atmosphäre darstellt. Danach wird das Substrat 10 so gedreht, daß die Komponente 18 entlang der Oberfläche 22 zu der genannten Ecke des Teilbereichs 14 gleitet.

Gemäß einer bevorzugten Variante der vorliegenden Erfindung wird die beschriebene Bewegung der Komponente 18 zu der vorbestimmten Stelle 24 beschleunigt, indem anstelle der Schwerkraft der Komponente 18 die Fliehkraft bzw. Zentrifugalkraft derselben in einer Zentrifuge verwendet wird.

Insbesondere bei Verwendung einer Zentrifuge ist anstelle einer Flüssigkeit mit einer niedrigen Viskosität auch eine Flüssigkeit mit einer hohen Viskosität bzw. eine Paste zur Bildung des Flüssigkeitsvolumens 16 verwendbar.

Alternativ oder zusätzlich zu der Schwerkraft können auf die Komponente 18 weitere Kräfte wirken, beispielsweise elektrostatische oder magnetische Kräfte, die von einem äußeren elektrischen bzw. magnetischen Feld erzeugt werden. Ein elektrisches Feld übt auf die Komponente 18 eine Kraft aus, wenn dieses eine elektrische (Monopol-) Ladung trägt. Diese Kraft wirkt parallel zu dem elektrischen Feld bzw. dessen "Feldlinien".

In einem inhomogenen elektrischen Feld wirkt auch auf eine ungeladene Komponente 18 eine Kraft, wenn sich die elektrische Polarisierbarkeit der Komponente 18 von der der umgebenden Flüssigkeit des Flüssigkeitsvolumens 16 unterscheidet.

Jedes elektrische Feld übt ferner auf die Komponente 18 ein ausrichtendes Drehmoment aus, wenn die Komponente 18 eine anisotrope Polarisierbarkeit aufweist. Eine anisotrope Polarisierbarkeit der Komponente 18 liegt beispielsweise vor, wenn die Komponente 18 eine längliche Form oder eine Plättchenform oder ein Material mit einer anisotropen Polarisierbarkeit oder Leiterstrukturen aufweist, die in einer Richtung eine leichtere Ladungsverschiebung ermöglichen als in einer dazu senkrechten Richtung.

Ein äußeres Magnetfeld übt auf eine Komponente 18 mit einem permanenten magnetischen Dipolmoment oder mit einer anisotropen Magnetisierbarkeit ein ausrichtendes Drehmoment aus. Ein inhomogenes äußeres Magnetfeld übt ferner eine (lineare) Kraft auf eine Komponente 18 mit einem magnetischen Dipolmoment aus.

Durch ein äußeres elektrisches oder magnetisches Feld kann somit die Komponente 18 innerhalb des Flüssigkeitsvolumens 16 translatorisch bewegt sowie ausgerichtet werden. Dabei sind neben den genannten permanenten oder induzierten elektrischen oder magnetischen Monopol- oder Dipolmomenten auch höhere Momente verwendbar. Ferner sind elektromagnetische Wechselfelder verwendbar.

Gemäß einer weiteren bevorzugten Variante wird durch ein Lichtfeld hoher Intensität, welches das Flüssigkeitsvolumen durchsetzt, eine Kraft auf die Komponente ausgeübt. Diese Kraft kann abhängig von der Beschaffenheit der Flüssigkeit, der Komponente und ihrer Oberfläche und von der Wellenlänge des verwendeten Lichts zwei Ursachen haben. Zum einen üben an der Komponente reflektierte oder absorbierte Photonen aufgrund des Impulses, den sie tragen, eine Kraft auf die Komponente aus. Zum anderen bewirkt die Absorption von Photonen eine Erwärmung der Oberfläche der Komponente und der an sie angrenzenden Flüssigkeitsschicht. Diese Erwärmung wiederum hat einen erhöhten Impulsübertrag zwischen Molekülen der Flüssigkeit und der Oberfläche der Komponente und damit einen erhöhten Druck zur Folge.

Fig. 2 ist eine schematische perspektivische Darstellung eines Substrats 10 mit einer Oberfläche 12 gemäß einem weiteren bevorzugten Ausführungsbeispiel der vorliegenden Erfindung. Ein Teilbereich 14 der Oberfläche 12 ist durch ein Flüssigkeitsvolumen 16 benetzt. Anordnung, Form und Größe des Teilbereichs 14 sind wie im vorangegangenen Ausführungsbeispiel durch den Ort, an dem das Flüssigkeitsvolumen 16 auf die Oberfläche 12 aufgebracht wurde, und die Größe des Flüssigkeitsvolumens 16 bestimmt oder durch Anordnung, Form und Größe des Teilbereichs 14, der sich in seinen Benetzungseigenschaften von einem angrenzenden Bereich der Oberfläche 12 unterscheidet. Dabei wird ein, wie in Fig. 2 dargestellt, von einer Kreisform deutlich abweichender Teilbereich 14 in der Regel nur auf die zweite Weise erzeugbar sein.

Innerhalb des Teilbereichs 14 existiert eine vorbestimmte Stelle 24, an der die Komponente 18 auf die Oberfläche 12 aufzubringen ist. Diese vorbestimmte Stelle 24 oder die Komponente 18 sind so ausgebildet, daß in dem in Fig. 2 dargestellten Zustand nach dem Aufbringen des Flüssigkeitsvolumens 16 auf die Oberfläche 12 des Substrats 10 eine Kraft auf die Komponente 18 wirkt, die ausreichend ist, um die Komponente 18 innerhalb des Flüssigkeitsvolumens 16 zu der vorbestimmten Stelle 24 zu treiben bzw. zu bewegen. Diese Kraft wirkt auf die Komponente 18 vorzugsweise bereits, wenn die Komponente 18 wie in Fig. 2 dargestellt, den Teilbereich 14 der Oberfläche 12 noch nicht berührt, sondern sich noch im Inneren des Flüssigkeitsvolumens 16 aufhält. Alternativ wirkt die Kraft erst dann, wenn die Komponente 18 den Teilbereich 14 der Oberfläche 12 punktuell oder flächig berührt. Die Kraft umfaßt vorzugsweise eine lineare Kraft, die die Komponente 18 zu der vorbestimmten Stelle 24 zieht. Alternativ oder zusätzlich sind die Komponente 18 und die vorbestimmte Stelle 24 an der Oberfläche 12 des Substrats 10 ferner so ausgebildet, daß ein ausrichtendes Drehmoment auf die Komponente 18 wirkt.

Die die Kraft oder das Drehmoment bewirkende Ausgestaltung der Komponente 18 oder der vorbestimmten Stelle 24 der Oberfläche 12 besteht vorzugsweise in einer entsprechenden bzw. korrespondierenden Formgebung der Komponente 18 und lateralen Strukturierung der Beschaffenheit der Oberfläche 12. Beispielsweise ist die Komponente 18 mit einer hydrophilen Oberfläche oder einem hydrophilen Teilbereich ihrer Oberfläche versehen. Die vorbestimmte Stelle 24 ist ebenfalls hydrophil, wobei Form und Größe der hydrophilen vorbestimmten Stelle 24 Form und Größe der Komponente 18 bzw. des hydrophilen Teilbereichs der Oberfläche der Komponente 18 entsprechen. Der die hydrophile vorbestimmte Stelle 24 umgebende Abschnitt des Teilbereichs 14 der Oberfläche 12 ist hydrophob. Die Komponente 18 wird in diesem Fall von dem hydrophoben Abschnitt des Teilbereichs 14 abgestoßen und von der hydrophilen vorbestimmten Stelle 24 angezogen. Bei einer wie in Fig. 2 dargestellten länglichen Formgebung der Komponente 18 und der vorbestimmten Stelle 24 erfolgt ferner eine Ausrichtung der Komponente 18 entsprechend der vorbestimmten Stelle 24.

Alternativ sind die vorbestimmte Stelle 24 und die Oberfläche der Komponente 18 oder ein Teilbereich derselben hydrophob bzw. lipophil ausgestaltet, wobei der die vorbestimmte Stelle 24 umgebende Abschnitt des Teilbereichs 14 hydrophil bzw. lipophob ausgebildet ist.

In beiden Fällen ist die Flüssigkeit des Flüssigkeitsvolumens 16 vorzugsweise so ausgebildet, daß sie sowohl hydrophile bzw. lipophobe als auch hydrophobe bzw. lipophile Oberflächen und damit den gesamten Teilbereich 14 der Oberfläche 12 einschließlich der vorbestimmten Stelle 24 sowie die gesamte Komponente 18 gegebenenfalls einschließlich aller hydrophiler und lipophiler Bereiche ihrer Oberfläche benetzt.

Alternativ oder zusätzlich werden andere Oberflächeneigenschaften lateral selektiv strukturiert, um die vorbestimmte Stelle 24 oder die vorbestimmte Ausrichtung der Komponente 18 auf der Oberfläche 12 des Substrats 10 zu definieren. Beispielsweise werden die Komponente 18 oder ein Teilbereich seiner Oberfläche und die vorbestimmte Stelle 24 an der Oberfläche 12 des Substrats 10 mit komplementären DNA-Einzelsträngen versehen, die bei einer Annäherung der Komponente 18 an die vorbestimmte Stelle 24 hybridisieren und so eine mechanische Verbindung zwischen der Komponente 18 und der Oberfläche 12 des Substrats 10 schaffen.

Um beispielsweise im Fall einer Komponente 18, deren Funktion von der Richtung ihres Einbaus bzw. ihrer Aufbringung auf die Oberfläche 12 des Substrats 10 abhängig ist, zu erreichen, daß die Komponente 18 nur mit einer vorbestimmten Richtung und nicht um 180° gegenüber dieser verdreht auf die vorbestimmte Stelle 24 der Oberfläche 12 des Substrats 10 aufgebracht wird, werden gemäß einer Variante des in Fig. 2 dargestellten Ausführungsbeispiels die beiden Enden der Komponente 18 sowie die beiden entsprechenden Enden der vorbestimmten Stelle 24 unterschiedlich ausgestaltet. Beispielsweise erhalten ein Ende der Komponente 18 und ein mit diesem zu verbindendes Ende der vorbestimmten Stelle 24 hydrophile Oberflächen, während das andere Ende der Komponente 18 und das mit diesem zu verbindende zweite Ende der vorbestimmten Stelle 24 eine lipophile Oberfläche erhalten.

Fig. 3 ist eine schematische Schnittdarstellung eines Substrats 10 mit einer Oberfläche 12 gemäß einem weiteren bevorzugten Ausführungsbeispiel der vorliegenden Erfindung. Die Oberfläche 12 weist eine Vertiefung bzw. eine Ausnehmung 26 auf. Mittels einer Tintenstrahldruckvorrichtung oder einer anderen geeigneten Vorrichtung wurde ein Flüssigkeitsvolumen 16 in der Ausnehmung 26 der Oberfläche 12 aufgetragen. Die Größe des Flüssigkeitsvolumens 16 und der Ort, an dem das Flüssigkeitsvolumen 16 auf die Oberfläche 12 aufgebracht wurde, wurden so gewählt, daß das Flüssigkeitsvolumen 16 die Oberfläche 12 nur innerhalb der Ausnehmung 26 benetzt. Anders ausgedrückt liegt der durch das Flüssigkeitsvolumen 16 benetzte Teilbereich 14 der Oberfläche 12 vollständig innerhalb der Ausnehmung 26.

Die Oberfläche 22 des Flüssigkeitsvolumens 16 liegt teilweise außerhalb des Raumbereichs, der durch die Ausnehmung 26 gebildet und durch die Ebene begrenzt wird, die durch die Oberfläche 12 außerhalb der Ausnehmung 26 definiert ist. Alternativ ist das Flüssigkeitsvolumen 16 so klein gewählt, daß seine Oberfläche 22 nicht über die durch die Oberfläche 12 außerhalb der Ausnehmung 26 definierte Ebene hinausreicht.

Die Ausnehmung 26 weist einen kreisbogenförmigen, U-förmigen, V-förmigen, kastenförmigen bzw. rechteckigen, trapezförmigen oder beliebigen anderen Querschnitt auf. In lateraler Richtung weist die Ausnehmung 26 die Form eines Kreises, eines Ellipsoids, eines Ovals, eines Rechtecks oder eine beliebige andere Form auf. Vorzugsweise ist die Ausnehmung 26 so gestaltet, daß sie sich nach unten hin, d. h. in das Substrat 10 hinein, verjüngt. Besonders bevorzugt weist die Ausnehmung 26 einen näherungsweise V- oder U-förmigen Querschnitt auf, wie er in Fig. 3 schematisch dargestellt ist.

Eine Komponente 18, die in dem Flüssigkeitsvolumen 16 enthalten ist, sinkt aufgrund der Einwirkung der Schwerkraft bis zu der Oberfläche 28 der Ausnehmung 26 herab und gleitet dann an dieser entlang bis zum tiefsten Punkt der Ausnehmung 26, der die für die Komponente 18 vorbestimmte Stelle 24 darstellt. Ähnlich wie bei dem mit Bezug auf Fig. 1 dargestellten Ausführungsbeispiel ist dabei das Substrat 10 mit der Oberfläche 12 vom Erdmittelpunkt abgewandt angeordnet, wenn die mittlere Dichte der Komponente 18 größer ist als die der Flüssigkeit des Flüssigkeitsvolumens 16. Wenn die Dichte der Flüssigkeit des Flüssigkeitsvolumens 16 größer ist als die mittlere Dichte der Komponente 18, wird das Substrat 10 dabei so ausgerichtet, daß dessen Oberfläche 12 dem Erdmittelpunkt zugewandt ist.

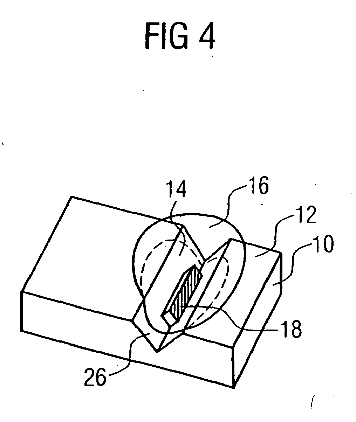

Eine Ausrichtung der Komponente 18 an der vorbestimmten Stelle 24 erfolgt, wie oben anhand der Fig. 2 beschrieben, durch eine besondere Ausgestaltung der Komponente 18 und der vorbestimmten Stelle 24, aus der ein ausrichtendes Drehmoment auf die Komponente 18 resultiert. Alternativ resultiert eine ausrichtende Kraft bzw. ein ausrichtendes Drehmoment auf die Komponente 18 ebenfalls aus der Form der Ausnehmung 26 und der Form der Komponente 18. Dies wird nachfolgend anhand der Fig. 4 näher beschrieben.

Fig. 4 ist eine schematische perspektivische Darstellung eines Substrats 10 mit einer Oberfläche 12 gemäß einem weiteren bevorzugten Ausführungsbeispiel der vorliegenden Erfindung. Die Oberfläche 12 des Substrats 10 weist, wie in dem anhand der Fig. 3 oben beschriebenen Ausführungsbeispiel, eine Ausnehmung 26 auf, die jedoch die Form einer Rinne bzw. Nut mit einem V-förmigen Querschnitt aufweist. Ein Flüssigkeitsvolumen 16 benetzt einen teilweise punktiert umrandet dargestellten Teilbereich 14 der Oberfläche 12 des Substrats 10 bzw. der Ausnehmung 26. Das Flüssigkeitsvolumen 16 enthält eine längliche, in diesem Beispiel quaderförmig dargestellte Komponente 18. Die Komponente 18 ist in dem in Fig. 4 dargestellten Zustand bereits an der Oberfläche 12 des Substrats 10 angeordnet. Aufgrund der Rinnenform der Ausnehmung 26 ist die Komponente 18 längs der Ausnehmung 26 ausgerichtet.

Der Ort der Komponente 18 innerhalb der Ausnehmung 26 ist in Richtung quer zu der Ausnehmung 26 durch deren Querschnitt eindeutig vorbestimmt. In Richtung parallel zu der Ausnehmung 26 ist die Anordnung der Komponente 18 nur grob durch die Ausdehnung des durch das Flüssigkeitsvolumen 16 benetzten Teilbereichs 14 der Oberfläche 12 bestimmt. Um auch in Richtung parallel zu der Ausnehmung 26 eine definierte Anordnung der Komponente 18 zu erzielen, werden alternativ Maßnahmen, wie sie oben anhand der Fig. 1 und 2 beschrieben wurden, ergriffen.

Nach dem Aufbringen des Flüssigkeitsvolumens 16, das die Komponente 18 enthält, auf die Oberfläche 12 des Substrats 10 und gegebenenfalls der genauen Anordnung oder Ausrichtung derselben an der vorbestimmten Stelle, wie sie oben mit Bezug auf die Fig. 1 - 4 beschrieben wurde, wird das Flüssigkeitsvolumen 16 entfernt. Dies geschieht vorzugsweise durch ein Abtrocknen bzw. ein Verdunsten der Flüssigkeit, das vorzugsweise durch Wärme oder Unterdruck bzw. Vakuum unterstützt bzw. beschleunigt wird.

Die Zeitdauer des Verdunstens des Flüssigkeitsvolumens 16 ist dabei auch von den Eigenschaften der Flüssigkeit des Flüssigkeitsvolumens 16 abhängig. Insbesondere wenn die Anlagerung und gegebenenfalls Ausrichtung der Komponente 18 an der vorbestimmten Stelle 24 an der Oberfläche 12, wie oben beschrieben, mechanisch (Gravitation), elektrisch oder magnetisch unterstützt bzw. beschleunigt wird, ist ein sehr schnell flüchtiges Medium bzw. eine sehr schnell flüchtige Flüssigkeit für das Flüssigkeitsvolumen 16 verwendbar. Durch das Verdunsten verringert sich das Flüssigkeitsvolumen 16, wodurch ebenfalls die Bewegung der Komponente 18 zu der vorbestimmten Stelle 24 beschleunigt werden kann.

Beim vollständigen Verdunsten des Flüssigkeitsvolumens 16 entstehen gemäß einem bevorzugten Ausführungsbeispiel der vorliegenden Erfindung elektrische Kontakte zwischen der Komponente 18 und der Oberfläche 12 des Substrats 10. Vorzugsweise wird die Komponente 18 gleichzeitig an der Oberfläche 12 des Substrats 10 fixiert.

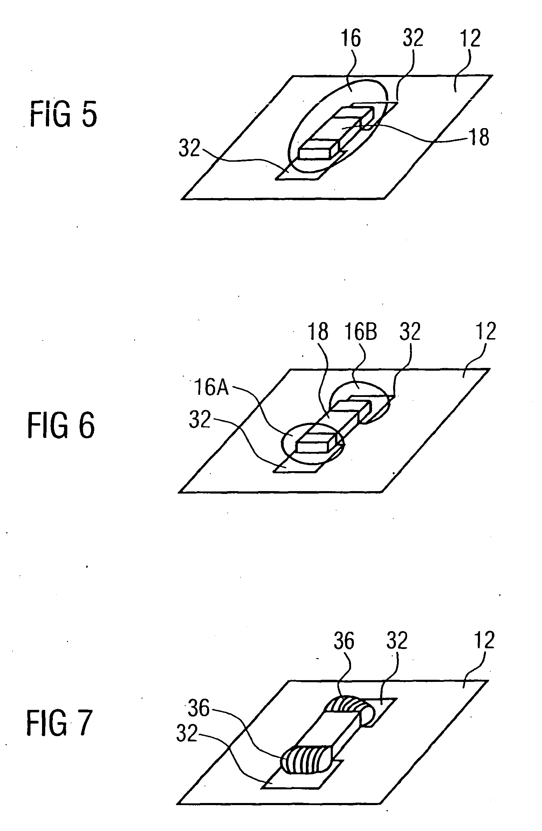

Die Fig. 5, 6 und 7 sind schematische perspektivische Darstellungen einer Oberfläche 12 eines Substrats mit zwei Kontaktflächen 32 und eines Chips oder einer anderen Komponente 18 in drei verschiedenen Stadien. Die Komponente 18 umfaßt Kontaktzonen 34, die dafür vorgesehen sind, mit den Kontaktflächen 32 elektrisch leitfähige Kontakte auszubilden. Die Kontaktzonen 34 der Komponente 18 sind an der Oberseite, der Unterseite, einer Seitenfläche oder den Stirnflächen der Komponente 18 angeordnet. Vorzugsweise erstreckt sich jede der Kontaktzonen 34 über mehrere Seiten der Komponente, wie es in den Fig. 5, 6 und 7 dargestellt ist.

Die Komponente 18 ist in Fig. 5 in einen Flüssigkeitstropfen bzw. ein Flüssigkeitsvolumen 16 eingebettet, das an der Oberfläche 12 des Substrats angeordnet ist. Dieser Zustand liegt beispielsweise unmittelbar nach dem Aufbringen der Komponente 18 in dem Flüssigkeitsvolumen 16 auf die Oberfläche 12 des Substrats vor.

Die Kontaktflächen 32 an der Oberfläche 12 des Substrats und die Kontaktzonen 34 der Komponente 18 sind so ausgebildet, daß sie von der Flüssigkeit des Flüssigkeitsvolumens 16 benetzt werden. Der Rest der Oberfläche 12 des Substrats und der Rest der Oberfläche der Komponente 18 sind so ausgebildet, daß sie von der Flüssigkeit des Flüssigkeitsvolumens 16 nicht benetzt werden. Anders ausgedrückt ziehen die Kontaktflächen 32 und die Kontaktzonen 34 die Flüssigkeit des Flüssigkeitsvolumens 16 an, wohingegen der Rest der Oberfläche 12 des Substrats und der Rest der Oberfläche der Komponente 18 die Flüssigkeit abstoßen. Wenn die Flüssigkeit des Flüssigkeitsvolumens 16 polar ist, beispielsweise eine wäßrige Lösung, sind die Kontaktflächen 32 und die Kontaktzonen 34 hydrophil und der Rest der Oberfläche 12 und der Rest der Oberfläche der Komponente 18 hydrophob ausgebildet. Wenn die Flüssigkeit des Flüssigkeitsvolumens 16 unpolar ist, beispielsweise eine ölige Flüssigkeit, sind die Kontaktflächen 32 und die Kontaktzonen 34 lipophil und der Rest der Oberfläche 12 und der Rest der Oberfläche der Komponente 18 lipophob ausgebildet.

Diese Ausgestaltung der Kontaktflächen 32, der Kontaktzonen 34 und der restlichen Anteile der Oberfläche 12 des Substrats und der Oberfläche der Komponente 18 hat eine spontane bzw. selbständige bzw. automatische Ausrichtung der Komponente 18 auf der Oberfläche 12 des Substrats zur Folge. Insbesondere richtet sich die Komponente 18 spontan so aus, daß die benetzten Kontaktzonen 34 der Komponente 18 an den Kontaktflächen 32 an der Oberfläche 12 des Substrats anliegen. Die Komponente 18 ist somit bereits so angeordnet und ausgerichtet, daß ohne weiteres elektrisch leitfähige Kontakte zwischen den Kontaktflächen 32 und den Kontaktzonen 34 ausgebildet werden können.

Fig. 6 zeigt die Oberfläche 12 des Substrats und die Komponente 18 zu einem Zeitpunkt, der nach dem in Fig. 5 dargestellten Zeitpunkt liegt. Ein Teil der Flüssigkeit des Flüssigkeitsvolumens 16 ist bereits verdunstet oder auf andere Weise entfernt. Wie erwähnt ziehen nur die Kontaktflächen 32 an der Oberfläche 12 des Substrats und die Kontaktzonen 34 der Komponente 18 die Flüssigkeit des Flüssigkeitsvolumens 16 an. Der Rest der Oberfläche 12 des Substrats und der Rest der Oberfläche der Komponente 18 stoßen die Flüssigkeit ab. Die verbleibende Flüssigkeit zieht sich deshalb spontan zu den Kontaktflächen 32 und den Kontaktzonen 34 zurück. Das Flüssigkeitsvolumen 16 teilt sich dabei, und es entstehen zwei kleine Flüssigkeitsvolumina 16a, 16b.

Fig. 7 zeigt die Oberfläche 12 des Substrats und die Komponente 18 zu einem noch späteren Zeitpunkt. Alle Anteile der Flüssigkeit, die bei den gegebenen Bedingungen einen ausreichenden Dampfdruck aufweisen, sind verdampft bzw. verdunstet. Zurückgeblieben sind lediglich Inhaltsstoffe 36 des Flüssigkeitsvolumens 16, die einen (näherungsweise) verschwindenden Dampfdruck aufweisen, beispielsweise (ursprünglich) suspendierte feste Partikel. Diese Inhaltsstoffe 36 haben sich an den Kontaktflächen 32 und den Kontaktzonen 34 abgelagert. Vorzugsweise sind diese Inhaltsstoffe so gewählt, daß sie dort eine Basis bzw. ein Ausgangsmaterial für eine Kontaktierung oder eine vorläufige Kontaktierung bilden. In einem nachfolgenden Verfahrensschritt erfolgt eine Umwandlung oder Verstärkung zu einer festen und dauerhaften Kontaktierung, beispielsweise durch eines oder mehrere Tauchbäder. Dabei kann abweichend von der Darstellung in den Fig. 5, 6 und 7 bei Komponenten 18 mit mehr als zwei Kontaktzonen 34 gleichzeitig eine entsprechende Anzahl von Kontakten gebildet werden.

Der in den Fig. 5, 6 und 7 dargestellte Prozeß kann durch eine Klebeschicht ergänzt werden, die an der Oberfläche 12 des Substrats zwischen den Kontaktflächen 32 und/oder an der Komponente 18 zwischen den Kontaktzonen 34 angeordnet ist. Die Klebeschicht wird vorzugsweise durch die Flüssigkeit des Flüssigkeitsvolumens 16 aktiviert. Nach dem Trocknen der Flüssigkeit des Flüssigkeitsvolumens 16 verfestigt sich die Klebeschicht und bildet eine stabile und dauerhafte mechanische Verbindung zwischen der Komponente 18 und der Oberfläche 12 des Substrats.

Das Flüssigkeitsvolumen 16 enthält vorzugsweise wäßrige alkoholische oder ölige Lösungen oder Kombinationen, beispielsweise eine Emulsion. Die Wahl der Eigenschaften der Lösung hängt von den Justierflächen ab. Wenn die Kontaktflächen 32 und die Kontaktzonen 34 hydrophil sind, enthält das Flüssigkeitsvolumen 16 vorzugsweise eine polare Flüssigkeit, beispielsweise eine wäßrige Lösung. Wenn die Kontaktflächen 32 und die Kontaktzonen 34 lipophil sind, enthält das Flüssigkeitsvolumen 16 vorzugsweise eine unpolare Flüssigkeit, beispielsweise eine ölige Lösung.

Gemäß einer bevorzugten Variante der vorliegenden Erfindung werden zwei verschiedene Flüssigkeiten verwendet, und zwar eine polare und eine unpolare. Zunächst wird beispielsweise eine alkoholische oder wäßrige Flüssigkeit auf die Oberfläche 12 des Substrats aufgedruckt, aufgespritzt oder auf eine andere Weise aufgebracht und bildet dort einen Tropfen oder ein anderes Flüssigkeitsvolumen 16. In dieses Flüssigkeitsvolumen 16 wird anschließend eine Komponente 18, beispielsweise ein Chip, eingebracht, der in eine ölige pastöse Lösung eingehüllt bzw. von dieser umgeben ist. Die Komponente 18 wird sich dann beispielsweise dort an der Oberfläche 12 des Substrats anlagern, wo diese lipophil ist.

Gemäß einer weiteren bevorzugten Variante wird eine Emulsion von öligen pastösen Tröpfchen, die jeweils mehrere, vorzugsweise jedoch eine Komponente 18 enthalten, in einer alkoholischen oder wäßrigen Lösung auf die Oberfläche 12 des Substrats aufgebracht. Zunächst bewirkt das alkoholische oder wäßrige Flüssigkeitsvolumen 16 eine Grobjustage des oder der öligen Tröpfchen auf gröberen Strukturen aus hydrophilen und hydrophoben Feldern. Nachdem der oder die öligen Tröpfchen auf dem Muster der Felder zentriert sind, und evtl. erst nach einem Verdunsten des alkoholischen oder wäßrigen Flüssigkeitsvolumens 16 erfolgt eine Justierung der öligen Tröpfchen mit den Komponenten 18 durch lipophile und lipophobe Felder. Nachdem ein öliges Tröpfchen auf einem inneren Feld justiert ist, benetzt es die Kontaktflächen 32 an der Oberfläche 12 des Substrats. Danach werden beispielsweise durch einen Sinterprozeß Kontakte zwischen Kontaktzonen 34 der Komponente, die in dem öligen Tröpfchen enthalten war, und den Kontaktflächen 32 an der Oberfläche des Substrats gebildet. Zur Ausbildung der Kontakte enthält das ölige Tröpfchen vorzugsweise eine metallische Komponente beispielsweise Nano-Lötzinnkugeln. Dieses Konzept kann nahezu beliebig erweitert, variiert und verfeinert werden.

Die vorliegende Erfindung ist in ganz besonderem Maße für Komponenten mit Abmessungen im Bereich unterhalb 1 mm bis herab zu 1 nm und darunter geeignet, da deren Masse klein ist. Die vorliegende Erfindung ist jedoch auch noch für Komponenten mit Abmessungen im Bereich von 1 mm und darüber geeignet, insbesondere wenn es sich beispielsweise um Komponenten bzw. Chips aus gedünnten Substraten handelt, die eine sehr geringe Masse aufweisen. Dabei sind vorteilhafter Weise die Eigenschaften der Flüssigkeit an die Größe, die Masse und die hydrodynamischen Eigenschaften der Komponente angepaßt. Allgemein ist für größere Komponenten und für Komponenten mit größerer Masse eine Flüssigkeit vorteilhaft, die größere Tropfen bildet. Eine harzige Flüssigkeit ermöglicht beispielsweise Tropfen mit Durchmessern im Bereich von mm bis cm.

Je größer und massereicher die einzelne Komponente ist, desto langsamer läuft das erfindungsgemäße Verfahren in der Regel ab. Um eine Limitierung des Durchsatzes zu verhindern, wird dann vorzugsweise die Parallelität erhöht, d. h. Teile des erfindungsgemäßen Verfahrens werden mehrfach oder vielfach parallel ausgeführt. Dies stellt jedoch keinen Nachteil dar, da das Verfahren insgesamt und insbesondere die geschwindigkeitsbestimmenden Schritte nur äußerst geringe Investitionen in Geräte erfordern und nur geringe sonstige Verfahrenskosten erzeugen.

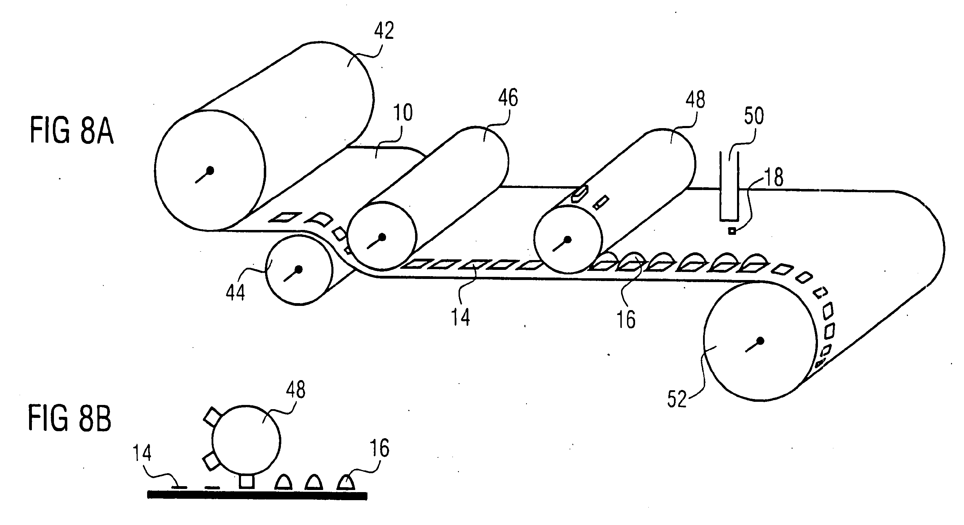

Alternativ zu den oben bereits erwähnten Druckverfahren ist ein Aufbringen der Flüssigkeitsvolumina mittels eines Rollendruckverfahrens bzw. eines Rolle-zu-Rolle-Verfahrens oder eines (großen) Paralleldispensers vorteilhaft. Dieses wird im folgenden anhand der Fig. 8A und 8B dargestellt. Fig. 8A ist eine schematische perspektivische Darstellung von einigen der wichtigsten Einrichtungen zur Durchführung eines Rollendruckverfahrens. Das Substrat 10, auf das die Komponenten 18 aufzubringen sind, besteht aus Papier, Kunststoff-Folie oder einem anderen folienartigen Material, das ggf. mit Leiterbahnen oder anderen Merkmalen bedruckt ist. Das Substrat 10 liegt zunächst in Form einer Rolle 42 vor, von dem es - vorzugsweise kontinuierlich - abgerollt wird. Das Substrat wird durch Führungs- und TransportWalzen oder -Rollen 44, 46 geführt und angetrieben bzw. transportiert. Mittels einer Walze 48 werden Flüssigkeitsvolumina 16 auf Teilbereiche 14 aufgetragen, die für die Komponenten 18 vorbestimmte Stellen 24 umfassen. Dazu sind beispielsweise Hoch- oder Tiefdruckverfahren verwendbar. Das Aufbringen der Flüssigkeitsvolumina 16 auf das Substrat 10 mittels der Walze 48 ist in Fig. 8B in einem Längsschnitt schematisch dargestellt.

Die Flüssigkeitsvolumina 16 enthalten vorzugsweise bereits die Komponenten 18. Alternativ werden die Komponenten 18 erst bei einer anschließenden Station in die Flüssigkeitsvolumina 16 eingebracht. Dies ist in Fig. 8A schematisch durch eine Düse 50 dargestellt, die eine Komponente 18 oder einen Flüssigkeitstropfen, der eine Komponente 18 enthält, in ein Flüssigkeitsvolumen 16 einspritzt.

Nachdem die Flüssigkeitsvolumina 16 und die Komponenten 18 auf das Substrat 10 aufgebracht sind, durchläuft das Substrat 10 vorzugsweise weitere Verfahrensschritte, wie sie bereits oben anhand der vorangehenden Ausführungsbeispiele dargestellt wurden. Diese weiteren Verfahrensschritte und für ihre Durchführung benötigte Einrichtungen sind in Fig. 8A nicht dargestellt. Zu den weiteren Verfahrensschritten zählen Schritte zum Trocknen bzw. Entfernen flüchtiger Anteile der Flüssigkeitsvolumina 16 und zum Ausbilden, Verstärken oder Stabilisieren von elektrischen Kontakten und mechanischen Verbindungen zwischen den Komponenten 18 und dem Substrat 10.

Vorzugsweise nach dem Trocknen der Flüssigkeitsvolumina 16 und der vollständigen Ausbildung der elektrischen Kontakte und der mechanischen Verbindungen wird das Substrat 10 auf eine weitere Rolle 52 aufgerollt. Diese Rolle 52 wird dann zu einer Vereinzelungseinrichtung transportiert, die räumlich beabstandet von den in Fig. 8A dargestellten Einrichtungen angeordnet sein kann. Dort wird das Substrat 10 vereinzelt. Durch Schneiden, Sägen oder ähnliche Verfahrensschritte wird das Substrat 10 längs und quer geteilt, um einzelne Bauelemente oder elektronische Schaltungen zu erhalten, die jeweils eine oder mehrere der Komponenten 18 umfassen.

Mit dem anhand der Fig. 8A und 8B beschriebenen Verfahren ist es möglich Komponenten mit Abmessungen im Bereich unterhalb eines mm, aber auch gedünnte Komponenten im Größenbereich eines mm zu assemblieren. Ein besonderer Vorteil der Verwendung eines Rollenverfahrens, wie es anhand der Fig. 8A und 8B dargestellt wurde, ist der extrem hohe erzielbare Durchsatz.

Ähnlich dem anhand der Fig. 8A und 8B dargestellten Rollendruckverfahren sind auch schnelle Seitenprozesse verwendbar. Dabei können neben flexiblen Substraten aus Folie, Papier oder anderen flexiblen Materialien auch feste bzw. unflexible, insbesondere spröde Substrate verwendet werden.

Vorzugsweise wird das Flüssigkeitsvolumen 16 aus einer Flüssigkeit gebildet bzw. entnommen, die eine Mehrzahl von untereinander gleichen Komponenten 18 enthält. Das Verhältnis der Anzahl der untereinander gleichen Komponenten 18 in der Flüssigkeit zu der Gesamtmenge der Flüssigkeit oder die Größe des Flüssigkeitsvolumens 16 werden dabei so gewählt, daß das Flüssigkeitsvolumen 16 mit einer für die jeweilige Anwendung als hinreichend angesehenen, vorbestimmten Wahrscheinlichkeit mindestens eine Komponente 18 umfaßt.

Alternativ wird nach dem Aufbringen des Flüssigkeitsvolumens 16 auf die Oberfläche 12 des Substrats 10 geprüft, ob das Flüssigkeitsvolumen 16 eine Komponente 18 enthält. Falls dies nicht der Fall ist, wird nach dem Abtrocknen bzw. Verdunsten des Flüssigkeitsvolumens 16 ein weiteres Flüssigkeitsvolumen 16 auf die Oberfläche 12 des Substrats 10 aufgebracht und dieser Vorgang solange wiederholt, bis ein Flüssigkeitsvolumen 16 auf die Oberfläche 12 des Substrats 10 aufgebracht wurde, das eine Komponente 18 enthält. Alternativ wird durch ein gesteuertes Verfahren ein Flüssigkeitsvolumen 16 erzeugt, das reproduzierbar genau eine Komponente 18 enthält.

Gemäß bevorzugten Varianten der vorliegenden Erfindung umfaßt das Flüssigkeitsvolumen mehrere verschiedene Komponenten. Das Flüssigkeitsvolumen wird dazu vorzugsweise aus einer Flüssigkeit gebildet, die von mehreren verschiedenen Komponenten-Typen jeweils eine Mehrzahl von Komponenten enthält. Die verschiedenen Komponenten unterscheiden sich vorzugsweise so, daß die anordnenden Kräfte oder die ausrichtenden Drehmomente selektiv auf die Komponenten wirken.

Anstelle einer Tintenstrahldruckvorrichtung kann zum Aufbringen des Flüssigkeitsvolumens 16 auf die Oberfläche 12 des Substrats 10 eine andere Tropfenerzeugungseinrichtung verwendet werden, durch die ein Flüssigkeitsvolumen 16 bzw. ein Tropfen erzeugbar ist. Beispielsweise kann ein Tropfen durch Einwirken seiner Schwerkraft oder einer Fliehkraft oder bei einer ruckartigen Bewegung der Tropfenerzeugungseinrichtung aufgrund seiner Trägheit von einer Nadel oder einer Düse abgelöst werden. Das Flüssigkeitsvolumen 16 bzw. der Tropfen wird dabei nach dem Ablösen von der Tropfenerzeugungseinrichtung vorzugsweise von seiner Oberflächenspannung zusammengehalten, wobei er in der Regel eine näherungsweise kugelförmige Gestalt annimmt.

In den oben dargestellten Ausführungsbeispielen wurden hydrophile bzw. lipophobe und hydrophobe bzw. lipophile Eigenschaften von Oberflächen und Flüssigkeiten verwendet, um ein räumlich selektives und/oder ausgerichtetes Anlagern von Komponenten zu bewirken. Alternativ werden andere Eigenschaften von Oberflächen und von Molekülen, die strukturiert auf Oberflächen aufgebracht werden können und deren Eigenschaften bestimmen, verwendet. Die bereits erwähnten DNA-Einzelsträngen bieten den Vorteil, daß sie eine elektrische Leitfähigkeit aufweisen, die zur Ausbildung von elektrischen Kontakten zwischen einer Komponente und dem Substrat dienen kann. Darüber hinaus sind beispielsweise auch harnsäureartige Stoffe bzw. Moleküle verwendbar.

Die vorliegende Erfindung ist sowohl als Verfahren als auch als eine Vorrichtung zum Herstellen eines Systems mit einem Substrat und einem an einer vorbestimmten Stelle einer Oberfläche des Substrats aufgebrachten Komponente implementierbar. Die erfindungsgemäße Vorrichtung umfaßt eine Einrichtung zum Erzeugen eines Flüssigkeitsvolumens, das die Komponente enthält, und eine Einrichtung zum Aufbringen des Flüssigkeitsvolumens, das die Komponente enthält, auf die Oberfläche des Substrats. Diese Einrichtungen sind, wie oben bereits erwähnt, beispielsweise ein Tintenstrahldruckkopf mit einer Tintenstrahldüse.

Die vorliegende Erfindung ist für den Aufbau von elektrischen, elektronischen, optischen, optoelektronischen und anderen Systemen verwendbar. Dabei sind Prozesse, Verfahrensschritte, Einrichtungen und Merkmale des Substrats, des Flüssigkeitsvolumens und der Komponente, die in den verschiedenen Ausführungsbeispielen dargestellt wurden, kombinierbar, um einzelne oder jeweils eine Mehrzahl von Komponenten, beispielsweise Chips zu einem System zu assemblieren. Die vorliegende Erfindung ermöglicht somit das Assemblieren bzw. Drucken von ganzen Chip-Assemblies.

## Patentansprüche

1. Verfahren zum Herstellen eines Systems mit einem Substrat (10) mit einer Oberfläche (12) und einer an einer vorbestimmten Stelle (24) der Oberfläche (12) des Substrats (10) aufgebrachten Komponente (18) mit folgenden Schritten:
Erzeugen eine Flüssigkeitsvolumens (16), das die Komponente (18) enthält; und
Aufbringen des Flüssigkeitsvolumens (16), das die Komponente (18) enthält, auf die Oberfläche (12) des Substrats (10), wobei das Flüssigkeitsvolumen (16) so dimensioniert ist, dass es nach dem Aufbringen nur einen Teilbereich (14) der Oberfläche (12) des Substrats (10) benetzt,
wobei bei dem Schritt des Aufbringens das Flüssigkeitsvolumen (16) so auf der Oberfläche (12) des Substrats (10) plaziert wird, dass der Teilbereich (14) der Oberfläche (12) die vorbestimmte Stelle (24) umfasst, und
wobei die Komponente (18) oder die vorbestimmte Stelle (24) der Oberfläche (12) des Substrats (10) so ausgebildet ist, dass nach dem Aufbringen des Flüssigkeitsvolumens (16) eine Kraft auf die Komponente (18) wirkt, die ausreichend ist, um die Komponente (18) innerhalb des Flüssigkeitsvolumens (16) zu der vorbestimmten Stelle (24) zu treiben,
wobei der Schritt des Aufbringens des Flüssigkeitsvolumens (16) einen Schritt des Durchführens eines Rotationsdruckverfahrens, des Durchführens eines Rollendruckverfahrens, des Durchführens eines Tintenstrahldruckverfahrens oder eines Aufbringens mittels eines Paralleldispensers aufweist.

2. Verfahren gemäss Anspruch 1, bei dem der Schritt des Erzeugens des Flüssigkeitsvolumens (16) einen Schritt des Einbringens der Komponente (18) in das Flüssigkeitsvolumen (16) umfasst.

3. Verfahren gemäss einem der Ansprüche 1 bis 2, bei dem das Flüssigkeitsvolumen (16) eine polare Flüssigkeit umfasst und der Teilbereich (24) der Oberfläche (12) einen hydrophilen Abschnitt umfasst, an den ein hydrophober Abschnitt der Oberfläche (12) angrenzt.

4. Verfahren gemäss einem der Ansprüche 1 bis 3, bei dem das Flüssigkeitsvolumen (16) eine unpolare Flüssigkeit umfasst und der Teilbereich (14) der Oberfläche (12) einen lipophilen Abschnitt umfasst, an den ein lipophober Abschnitt der Oberfläche (12) angrenzt.

5. Verfahren gemäß Anspruch 5 oder 6, ferner mit einem Schritt des Erzeugens des hydrophilen und des hydrophoben Abschnitts bzw. des lipophilen und des lipophoben Abschnitts der Oberfläche (12).

6. Verfahren gemäß Anspruch 1 bis 5,
bei dem der Schritt des Erzeugens des Flüssigkeitsvolumens (16) ferner einen Schritt des Erzeugens eines hydrophilen Abschnitts auf der Komponente (18) umfasst, ferner mit einem Schritt des Erzeugens eines hydrophilen Abschnitts an der vorbestimmten Stelle (24) der Oberfläche (12) des Substrats (10),
wobei die Kraft, die auf die Komponente einwirkt, eine anziehende Kraft zwischen den hydrophilen Abschnitten auf der Komponente (18) und an der vorbestimmten Stelle (24) der Oberfläche (12) des Substrats (10) ist.

7. Verfahren gemäß Anspruch 1 bis 5,
bei dem der Schritt des Erzeugens des Flüssigkeitsvolumens (16) ferner einen Schritt des Erzeugens eines lipophilen Abschnitts auf der Komponente (18) umfasst, ferner mit einem Schritt des Erzeugens eines lipophilen Abschnitts an der vorbestimmten Stelle (24) der Oberfläche (12) des Substrats (10), wobei die Kraft, die auf die Komponente (18) wirkt, eine anziehende Kraft zwischen den lipophilen Abschnitten auf der Komponente (18) und an der vorbestimmten Stelle (24) der Oberfläche (12) des Substrats (10) ist.

8. Verfahren gemäß Anspruch 1 bis 7, bei dem die Komponente (18) und die vorbestimmte Stelle (24) der Oberfläche (12) des Substrats (10) ferner so ausgebildet sind, dass nach dem Aufbringen des Flüssigkeitsvolumens (16) eine ausrichtende Kraft auf die Komponente (18) wirkt, die ausreichend ist, um die Komponente (18) innerhalb des Flüssigkeitsvolumens (16) in einer vorbestimmten Weise auszurichten.

9. Verfahren gemäß Anspruch 8, bei dem die Komponente (18) und die vorbestimmte Stelle (24) der Oberfläche (12) des Substrats (10) jeweils einen oder mehrere hydrophile oder lipophile Abschnitte umfassen, die derart ausgebildet sind, dass die ausrichtende Kraft zumindest teilweise aus anziehenden Kräften zwischen hydrophilen Abschnitten oder zwischen lipophilen Abschnitten herrührt.

10. Verfahren gemäß Anspruch 8 oder 9, bei dem die ausrichtende Kraft zumindest teilweise durch Oberflächenstrukturen an der Komponente (18) oder an der Oberfläche (12) des Substrats (10) bewirkt wird.

11. Verfahren gemäß Anspruch 1 bis 10, ferner mit einem Schritt des Trocknens des Flüssigkeitsvolumens (16).

12. Verfahren gemäß Anspruch 11, bei dem der Schritt des Trocknens einen Schritt des Ausbildens eines elektrischen Kontakts zwischen dem Substrat (10) und der Komponente (18) umfasst.

13. Verfahren gemäß Anspruch 1 bis 12, bei dem das Substrat (10) eine Leiterplatte, ein keramisches Substrat, ein Halbleitersubstrat, Papier, Karton oder eine Kunststoff-Folie ist.

14. Verfahren gemäß Anspruch 1 bis 13, bei dem die Komponente (18) ein mikroelektronisches oder mikromechanisches Bauelement ist.

15. Verfahren gemäß Anspruch 1 bis 14, bei dem der Schritt des Erzeugens des Flüssigkeitsvolumens (16) einen Schritt des Einbringens einer Mehrzahl von untereinander gleichen Komponenten in eine Flüssigkeit und einen Schritt des Entnehmens des Flüssigkeitsvolumens (16) aus der Flüssigkeit umfasst, wobei die Komponente (18) eine der Mehrzahl von untereinander gleichen Komponenten ist.

16. Verfahren gemäß Anspruch 15, bei dem die Mehrzahl so gewählt wird, dass das Flüssigkeitsvolumen (16) mit einer vorbestimmten Wahrscheinlichkeit mindestens eine der Mehrzahl von untereinander gleichen Komponenten enthält.

17. Flüssigkeit, die eine Mehrzahl von untereinander gleichen Komponenten enthält, zum Durchführen eines Verfahrens gemäß Anspruch 15 oder 16.

18. Vorrichtung zum Herstellen eines Systems mit einem Substrat (10) mit einer Oberfläche (12) und einer an einer vorbestimmten Stelle (24) der Oberfläche (12) des Substrats (10) aufgebrachten Komponente (18) mit folgenden Merkmalen:
einer Einrichtung zum Erzeugen eines Flüssigkeitsvolumens (16), das die Komponente (18) enthält; und
einer Einrichtung zum Aufbringen des Flüssigkeitsvolumens (16), das die Komponente (18) enthält, auf die Oberfläche (12) des Substrats (10),
wobei das Flüssigkeitsvolumen (16) so dimensioniert ist, dass es nach dem Aufbringen nur einen Teilbereich (14) der Oberfläche (12) des Substrats (10) benetzt,
wobei die Einrichtung zum Aufbringen des Flüssigkeitsvolumens so ausgebildet ist, dass das Flüssigkeitsvolumen (16) so auf der Oberfläche (12) des Substrats (10) plazierbar ist, dass der Teilbereich (14) der Oberfläche (12) die vorbestimmte Stelle (24) umfasst,
wobei die Komponente (18) oder die vorbestimmte Stelle (24) der Oberfläche (12) des Substrats (10) so ausgebildet ist, dass nach dem Aufbringen des Flüssigkeitsvolumens (16) eine Kraft auf die Komponente (18) wirkt, die ausreichend ist, um die Komponente (18) innerhalb des Flüssigkeitsvolumens zu der vorbestimmten Stelle zu treiben, und
wobei die Einrichtung zum Aufbringen des Flüssigkeitsvolumens (16) eine Einrichtung zum Durchführen eines Rotationsdruckverfahrens, eine Einrichtung zum Durchführen eines Rollendruckverfahrens, eine Einrichtung zum Durchführen eines Tintenstrahldruckverfahrens oder einen Paralleldispenser aufweist.

19. Verfahren zum Herstellen eines Systems mit einem Substrat (10) mit einer Oberfläche (12) und einer an einer vorbestimmten Stelle (24) der Oberfläche (12) des Substrats (10) aufgebrachten Komponente (18) mit folgenden Schritten:
Erzeugen eine Flüssigkeitsvolumens (16), das die Komponente (18) enthält; und
Aufbringen des Flüssigkeitsvolumens (16), das die Komponente (18) enthält, auf die Oberfläche (12) des Substrats (10), wobei das Flüssigkeitsvolumen (16) so dimensioniert ist, dass es nach dem Aufbringen nur einen Teilbereich (14) der Oberfläche (12) des Substrats (10) benetzt,
wobei bei dem Schritt des Aufbringens das Flüssigkeitsvolumen (16) so auf der Oberfläche (12) des Substrats (10) plaziert wird, dass der Teilbereich (14) der Oberfläche (12) die vorbestimmte Stelle (24) umfasst,
wobei die Komponente (18) oder die vorbestimmte Stelle (24) der Oberfläche (12) des Substrats (10) so ausgebildet ist, dass nach dem Aufbringen des Flüssigkeitsvolumens (16) eine Kraft auf die Komponente (18) wirkt, die ausreichend ist, um die Komponente (18) innerhalb des Flüssigkeitsvolumens (16) zu der vorbestimmten Stelle (24) zu treiben, und
wobei das Flüssigkeitsvolumen (16) ein Tropfen ist, der durch seine Oberflächenspannung zusammengehalten wird, und wobei der Schritt des Erzeugens des Tropfens einen Schritt des Ablösens des Tropfens von einer Tropfenerzeugungseinrichtung aufgrund seiner Trägheit, durch Einwirken seiner Schwerkraft oder einer Fliehkraft umfasst.

20. Vorrichtung zum Herstellen eines Systems mit einem Substrat (10) mit einer Oberfläche (12) und einer an einer vorbestimmten Stelle (24) der Oberfläche (12) des Substrats (10) aufgebrachten Komponente (18) mit folgenden Merkmalen:
einer Einrichtung zum Erzeugen eines Flüssigkeitsvolumens (16), das die Komponente (18) enthält; und
einer Einrichtung zum Aufbringen des Flüssigkeitsvolumens (16), das die Komponente (18) enthält, auf die Oberfläche (12) des Substrats (10),
wobei das Flüssigkeitsvolumen (16) so dimensioniert ist, dass es nach dem Aufbringen nur einen Teilbereich (14) der Oberfläche (12) des Substrats (10) benetzt,
wobei die Einrichtung zum Aufbringen des Flüssigkeitsvolumens so ausgebildet ist, dass das Flüssigkeitsvolumen (16) so auf der Oberfläche (12) des Substrats (10) plazierbar ist, dass der Teilbereich (14) der Oberfläche (12) die vorbestimmte Stelle (24) umfasst,
wobei die Komponente (18) oder die vorbestimmte Stelle (24) der Oberfläche (12) des Substrats (10) so ausgebildet ist, dass nach dem Aufbringen des Flüssigkeitsvolumens (16) eine Kraft auf die Komponente (18) wirkt, die ausreichend ist, um die Komponente (18) innerhalb des Flüssigkeitsvolumens zu der vorbestimmten Stelle zu treiben,
wobei das Flüssigkeitsvolumen (16) ein Tropfen ist, der durch seine Oberflächenspannung zusammengehalten wird, und wobei die Einrichtung zum Erzeugen des Flüssigkeitsvolumens ausgebildet ist, um ein Ablösen des Tropfens von der Einrichtung zum Erzeugen aufgrund seiner Trägheit, durch Einwirken seiner Schwerkraft oder einer Fliehkraft zu bewirken.

## Claims

1. A method for producing a system comprising a substrate (10) having a surface (12) and a device component (18) applied to a predetermined location (24) of the surface (12) of the substrate (10), comprising the following steps:
generating a liquid volume (16) containing the device component (18); and
applying the liquid volume (16) containing the device component (18) onto the surface (12) of the substrate (10), wherein the liquid volume (16) is sized so that it wets only a partial area (14) of the surface (12) of the substrate (10) after its application,
wherein in the step of applying, the liquid volume (16) is placed on the surface (12) of the substrate (10) so that the partial area (14) of the surface (12) includes the predetermined location (24), and
wherein the device component (18) or the predetermined location (24) of the surface (12) of the substrate (10) is implemented so that after the application of the liquid volume (16) a force acts on the device component (18) which is sufficient in order to drive the device component (18) within the liquid volume (16) to the predetermined location (24),
wherein the step of applying the liquid volume (16) comprises a step of performing a rotation printing method, of performing a roller printing method, of performing an inkjet printing method or of application by means of a parallel dispenser.

2. The method according to claim 1, wherein the step of generating the liquid volume (16) includes a step of introducing the device component (18) into the liquid volume (16).

3. The method according to one of claims 1 to 2, wherein the liquid volume (16) includes a polar liquid and the partial area (24) of the surface (12) includes a hydrophilic portion which a hydrophobic portion of the surface (12) is adjacent to.

4. The method according to any of claims 1 to 3, wherein the liquid volume (16) includes a non-polar liquid and wherein the partial area (14) of the surface (12) includes a lipophilic portion which a lipophobic portion of the surface (12) is adjacent to.

5. The method according to claim 5 or 6, further comprising a step of generating the hydrophilic and the hydrophobic portion or the lipophilic and the lipophobic portion, respectively, of the surface (12).

6. The method according to any of claims 1 to 5,
wherein the step of generating the liquid volume (16) further includes a step of generating a hydrophilic portion on the device component (18), further comprising a step of generating a hydrophilic portion at the predetermined location (24) of the surface (12) of the substrate (10),
wherein the force acting on the device component (18) is an attractive force between the hydrophilic portions on the device component (18) and at the predetermined location (24) of the surface (12) of the substrate (10).

7. The method according to any of claims 1 to 5,
wherein the step of generating the liquid volume (16) further includes a step of generating a lipophilic portion on the device component (18), further comprising a step of generating a lipophilic portion at the predetermined location (24) of the surface (12) of the substrate (10),
wherein the force acting on the device component (18) is an attractive force between the lipophilic portions on the device component (18) and at the predetermined location (24) of the surface (12) of the substrate (10).

8. The method according to any of claims 1 to 7, wherein the device component (18) and the predetermined location (24) of the surface (12) of the substrate (10) are further implemented so that after the application of the liquid volume (16) an aligning force acts on the device component (18) which is sufficient in order to align the device component (18) within the liquid volume (16) in a predetermined way.

9. The method according to claim 8, wherein the device component (18) and the predetermined location (24) of the surface (12) of the substrate (10) respectively include one or several hydrophilic or lipophilic portions implemented such that the aligning force at least partially results from attractive forces between hydrophilic portions or between lipophilic portions.

10. The method according to claim 8 or 9, wherein the aligning force is at least partially caused by surface structures at the device component (18) or at the surface (12) of the substrate (10).

11. The method according to any of claims 1 to 10, further comprising a step of drying the liquid volume (16).

12. The method according to claim 11, wherein the step of drying includes a step of implementing an electrical contact between the substrate (10) and the device component (18).

13. The method according to any of claims 1 to 12, wherein the substrate (10) is a printed circuit board, a ceramic substrate, a semiconductor substrate, paper, carton or a plastics foil.

14. The method according to any of claims 1 to 13, wherein the device component (18) is a microelectronic or micro-mechanical device.

15. The method according to any of claims 1 to 14, wherein the step of generating the liquid volume (16) includes a step of introducing a plurality of device components that are equal to each other into a liquid and a step of removing the liquid volume (16) from the liquid, the device component (18) being one of the plurality of device components equal to each other.

16. The method according to claim 15, wherein the plurality is selected such that the liquid volume (16) contains at least one of the plurality of device components equal to each other with a predetermined probability.

17. Liquid containing a plurality of device components equal to each other for performing a method according to claim 15 or 16.

18. Device for producing a system comprising a substrate (10) having a surface (12) and a device component (18) applied to a predetermined location (24) of the surface (12) of the substrate (10), comprising the following features:
a means for generating a liquid volume (16) containing the device component (18); and
a means for applying the liquid volume (16) containing the device component (18) onto the surface (12) of the substrate (10),
wherein the liquid volume (16) is sized so that it wets only a partial area (14) of the surface (12) of the substrate (10) after its application,
wherein the means for applying the liquid volume is configured such that the liquid volume (16) may be placed on the surface (12) of the substrate (10) so that the partial area (14) of the surface (12) includes the predetermined location (24),
wherein the device component (18) or the predetermined location (24) of the surface (12) of the substrate (10) is implemented so that after the application of the liquid volume (16) a force acts on the device component (18) which is sufficient in order to drive the device component (18) within the liquid volume to the predetermined location, and
wherein the means for applying the liquid volume (16) comprises a means for performing a rotation printing method, a means for performing a roller printing method, a means for of performing an inkjet printing method or a parallel dispenser.

19. Method for producing a system comprising a substrate (10) having a surface (12) and a device component (18) applied to a predetermined location (24) of the surface (12) of the substrate (10), comprising the following steps:
generating a liquid volume (16) containing the device component (18); and
applying the liquid volume (16) containing the device component (18) onto the surface (12) of the substrate (10), wherein the liquid volume (16) is sized so that it wets only a partial area (14) of the surface (12) of the substrate (10) after its application,
wherein in the step of applying, the liquid volume (16) is placed on the surface (12) of the substrate (10) so that the partial area (14) of the surface (12) includes the predetermined location (24),
wherein the device component (18) or the predetermined location (24) of the surface (12) of the substrate (10) is implemented so that after the application of the liquid volume (16) a force acts on the device component (18) which is sufficient in order to drive the device component (18) within the liquid volume (16) to the predetermined location (24), and
wherein the liquid volume (16) is a drop, which is held together by its surface tension, and wherein the step of generating the drop includes a step of detaching the drop from its drop generating device due to its inertia, by an influence of its gravitational force or a centrifugal force.

20. Device for producing a system comprising a substrate (10) having a surface (12) and a device component (18) applied to a predetermined location (24) of the surface (12) of the substrate (10), comprising the following features:
a means for generating a liquid volume (16) containing the device component (18); and
a means for applying the liquid volume (16) containing the device component (18) onto the surface (12) of the substrate (10),
wherein the liquid volume (16) is sized so that it wets only a partial area (14) of the surface (12) of the substrate (10) after its application,
wherein the means for applying the liquid volume is configured such that the liquid volume (16) may be placed on the surface (12) of the substrate (10) so that the partial area (14) of the surface (12) includes the predetermined location (24), and
wherein the device component (18) or the predetermined location (24) of the surface (12) of the substrate (10) is implemented so that after the application of the liquid volume (16) a force acts on the device component (18) which is sufficient in order to drive the device component (18) within the liquid volume to the predetermined location,
wherein the liquid volume (16) is a drop, which is held together by its surface tension, and wherein the means for generating the liquid volume is configured to effect detachment of the drop from the means for generating due to its inertia, by an influence of its gravitational force or a centrifugal force.

## Revendications

1. Procédé pour réaliser un système avec un substrat (10) avec une surface (12) et un composant (18) appliqué à un endroit prédéterminé (24) de la surface (12) du substrat (10), aux étapes suivantes consistant à:
générer un volume de liquide (16) contenant le composant (18); et
appliquer le volume de liquide (16) contenant le composant (18) sur la surface (12) du substrat (10), le volume de liquide (16) étant dimensionné de sorte qu'après l'application il n'humidifie qu'une zone partielle (14) de la surface (12) du substrat (10),
à l'étape d'application, le volume de liquide (16) étant placé sur la surface (12) du substrat (10) de sorte que la zone partielle (14) de la surface (12) comprenne l'endroit prédéterminé (24), et
le composant (18) ou l'endroit prédéterminé (24) de la surface (12) du substrat (10) étant réalisé de sorte qu'après l'application du volume de liquide (16) agisse sur le composant (18) une force qui est suffisante pour amener le composant (18) dans le volume de liquide (16) à l'endroit prédéterminé (24),
l'étape d'application du volume de liquide (16) présentant une étape consistant à réaliser un procédé d'impression sur rotative, à réaliser un procédé d'impression par rouleaux, à réaliser un procédé d'impression par jet d'encre ou par application au moyen d'un distributeur parallèle.

2. Procédé selon revendication 1, dans lequel l'étape de génération du volume de liquide (16) comporte une étape consistant à introduire le composant (18) dans le volume de liquide (16).

3. Procédé selon l'une de revendications 1 à 2, dans lequel le volume de liquide (16) comporte un liquide polaire et la zone partielle (24) de la surface (12) comporte un segment hydrophile auquel est adjacent un segment hydrophobe de la surface (12).

4. Procédé selon l'une de revendications 1 à 3, dans lequel le volume de liquide (16) comporte un liquide apolaire et la zone partielle (14) de la surface (12) comporte un segment lipophile, auquel est adjacent un segment lipophobe de la surface (12).

5. Procédé selon revendication 5 ou 6, avec par ailleurs une étape consistant a générer le segment hydrophile et le segment hydrophobe ou le segment lipophile et le segment lipophobe de la surface (12).

6. Procédé selon revendication 1 à 5,
dans lequel l'étape de génération du volume de liquide (16) comporte par ailleurs une étape consistant à générer un segment hydrophile sur le composant (18), par ailleurs avec une étape consistant à générer un segment hydrophile à l'endroit prédéterminé (24) de la surface (12) du substrat (10),
la force agissant sur le composant étant une force d'attraction entre les segments hydrophiles sur le composant (18) et à l'endroit prédéterminé (24) de la surface (12) du substrat (10).

7. Procédé selon la revendication 1 à 5,
dans lequel l'étape de génération du volume de liquide (16) comporte par ailleurs une étape consistant à générer un segment lipophile sur le composant (18), par ailleurs avec une étape consistant à générer un segment lipophile à l'endroit prédéterminé (24) de la surface (12) du substrat (10),
la force agissant sur le composant (18) étant une force d'attraction entre les segments lipophiles sur le composant (18) et à l'endroit prédéterminé (24) de la surface (12) du substrat (10).

8. Procédé selon la revendication 1 à 7, dans lequel le composant (18) et l'endroit prédéterminé (24) de la surface (12) du substrat (10) sont par ailleurs réalisés de sorte qu'après l'application du volume de liquide (16) agisse sur le composant (18) une force d'orientation qui est suffisante pour orienter le composant (18) dans le volume de liquide (16) de manière prédéterminée.

9. Procédé selon la revendication 8, dans lequel le composant (18) et l'endroit prédéterminé (24) de la surface (12) du substrat (10) comportent, chacun, un ou plusieurs segments hydrophiles ou lipophiles qui sont réalisés de sorte que la force d'orientation résulte au moins partiellement de forces d'attraction entre les segments hydrophiles ou entre les segments lipophiles.

10. Procédé selon la revendication 8 ou 9, dans lequel la force d'orientation est provoquée au moins partiellement par des structures superficielles au composant (18) ou à la surface (12) du substrat (10).

11. Procédé suivant la revendication 1 à 10, par ailleurs avec une étape consistant à sécher le volume de liquide (16).

12. Procédé selon la revendication 11, dans lequel l'étape de séchage comporte une étape consistant à former un contact électrique entre le substrat (10) et le composant (18).

13. Procédé selon la revendication 1 a 12, dans lequel le substrat (10) est une plaque de conducteurs, un substrat céramique, un substrat semi-conducteur, du papier, du carton, ou un film plastique.

14. Procédé selon la revendication 1 à 13, dans lequel le composant (18) est un composant microélectronique ou micromécanique.

15. Procédé selon la revendication 1 à 14, dans lequel l'étape de génération du volume de liquide (16) comporte une étape consistant à introduire une pluralité de composants identiques entre eux dans un liquide et une étape consistant à prélever le volume de liquide (16) du liquide, le composant (18) étant l'un parmi la pluralité de composants identiques entre eux.

16. Procédé selon la revendication 15, dans lequel la pluralité est choisie de sorte que le volume de liquide (16) contienne avec une probabilité prédéterminée au moins l'un parmi la pluralité de composants identiques entre eux.

17. Liquide contenant une pluralité de composants identiques entre eux, pour réaliser un procédé selon la revendication 15 ou 16.

18. Dispositif pour réaliser un système avec un substrat (10) avec une surface (12) et un composant (18) appliqué à un endroit prédéterminé (24) de la surface (12) du substrat (10), aux caractéristiques suivantes:
un moyen destiné à générer un volume de liquide (16) contenant le composant (18); et
un moyen destiné à appliquer le volume de liquide (16) contenant le composant (18) sur la surface (12) du substrat (10),
le volume de liquide (16) étant dimensionné de sorte qu'après l'application, il n'humidifie qu'une zone partielle (14) de la surface (12) du substrat (10),
le moyen destiné à appliquer le volume de liquide étant réalisé de sorte que le volume de liquide (16) puisse être placé sur la surface (12) du substrat (10) de sorte que la zone partielle (14) de la surface (12) comporte l'endroit prédéterminé (24),
le composant (18) ou l'endroit prédéterminé (24) de la surface (12) du substrat (10) étant réalisé de sorte qu'après l'application du volume de liquide (16) agisse sur le composant (18) une force qui est suffisante pour amener le composant (18) dans le volume de liquide à l'endroit prédéterminé, et
le moyen destiné à appliquer le volume de liquide (16) présentent un moyen pour réaliser un procédé d'impression sur rotative, un moyen pour réaliser un procédé d'impression par rouleaux, un moyen pour réaliser un procédé d'impression par jet d'encre ou un distributeur parallèle.

19. Procédé pour réaliser un système avec un substrat (10) avec une surface (12) et un composant (18) appliqué à un endroit prédéterminé (24) de la surface (12) du substrat (10), aux étapes suivantes consistant à:
générer un volume de liquide (16) contenant le composant (18); et
appliquer le volume de liquide (16) contenant le composant (18) sur la surface (12) du substrat (10), le volume de liquide (16) étant dimensionné de sorte qu'après l'application ne soit humidifiée qu'une zone partielle (14) de la surface (12) du substrat (10),
à l'étape d'application, le volume de liquide (16) étant placé sur la surface (12) du substrat (10) de sorte que la zone partielle (14) de la surface (12) comprenne l'endroit prédéterminé (24),
le composant (18) ou l'endroit prédéterminé (24) de la surface (12) du substrat (10) étant réalisé de sorte qu'après l'application du volume de liquide (16) agisse sur le composant une force qui est suffisante pour amener le composant (18) dans le volume de liquide (16) à l'endroit prédéterminé (24), et
le volume de liquide (16) étant une goutte qui est maintenue ensemble par sa tension superficielle, et l'étape de génération de la goutte comportant une étape consistant à détacher la goutte d'un moyen de génération de gouttes sur base de son inertie, par l'action de sa force de gravité ou d'une force centrifuge.

20. Dispositif pour réaliser un système avec un substrat (10) avec une surface (12) et un composant (18) appliqué à un endroit prédéterminé (24) de la surface (12) du substrat (10), aux caractéristiques suivantes:
un moyen destiné à générer un volume de liquide (16) contenant le composant (18); et
un moyen destiné à appliquer le volume de liquide (16) contenant le composant (18) sur la surface (12) du substrat (10),
le volume de liquide (16) étant dimensionné de sorte qu'après l'application ne soit humidifiée qu'une zone partielle (14) de la surface (12) du substrat (10),
le moyen destiné à appliquer le volume de liquide étant réalisé de sorte que le volume de liquide (16) puisse être placé sur la surface (12) du substrat (10) de sorte que la zone partielle (14) de la surface (12) comporte l'endroit prédéterminé (24),
le composant (18) ou l'endroit prédéterminé (24) de la surface (12) du substrat (10) étant réalisé de sorte qu'après l'application du volume de liquide (16) agisse une force sur le composant (18) qui est suffisante pour amener le composant (18) dans le volume de liquide à l'endroit prédéterminé,
le volume de liquide (16) étant une goutte qui est maintenue ensemble par sa tension superficielle, et le moyen destiné a générer le volume de liquide étant réalisé pour détacher la goutte du moyen destiné à générer sur base de son inertie, par l'action de sa force de gravité ou d'une force centrifuge.
